# EUROPÄISCHE PATENTSCHRIFT

(11) **EP 2 697 832 B1**
(45) Veröffentlichungstag und Bekanntmachung des Hinweises auf die Patenterteilung: **04.01.2017**
(21) Anmeldenummer: 12715912.7
(22) Anmeldetag: 12.04.2012
(51) Int. Cl.: H01L 31/0224, H01L 31/02

(54) **SOLARZELLE**
SOLAR CELL
CELLULE SOLAIRE

(30) Priorität: 12.04.2011 DE 102011001999
(43) Veröffentlichungstag der Anmeldung: 19.02.2014
(73) Patentinhaber: Fraunhofer Gesellschaft zur Förderung der angewandten Forschung e.V., 80686 München (DE)
(72) Erfinder: VON CAMPE, Hilmar, 61352 Bad Homburg (DE); ROTH, Peter, 63450 Hanau (DE)
(74) Vertreter: Stoffregen, Hans-Herbert
(86) Internationale Anmeldenummer: PCT/EP2012/056673
(87) Internationale Veröffentlichungsnummer: WO 2012/140139

(56) Entgegenhaltungen:
- EP-A1- 1 936 699
- EP-A2- 1 811 576
- WO-A1-2008/139787
- DE-A1-102009 026 027
- US-A1- 2010 000 602

## Beschreibung

Die Erfindung bezieht sich auf eine Solarzelle umfassend ein Halbleitersubstrat mit Front- und Rückseitenkontakt, wobei der Frontseitenkontakt Kontaktfinger und zumindest einen quer zu diesen verlaufenden aus mehreren zueinander beabstandeten Abschnitten bestehenden Busbar umfasst, entlang dem ein mit diesem stoffschlüssig verbundener Verbinder verläuft, wobei zumindest zwei Kontaktfinger mit jeweils einem zumindest zwei Lötkanten aufweisenden Abschnitt des Busbars verbunden sind. Die Kontaktfinger verlaufen vorzugsweise parallel zueinander.

Bei der Herstellung von kristallinen Silicium-Solarzellen, auf die sich die Erfindung bezieht, werden üblicherweise gesägte Si-Wafer mittels eines Ätzbades texturiert. Anschließend kann entsprechend einer Standardtechnik Phosphor in eine Seite des Wafers eindiffundiert werden, um einen pn-Übergang auszubilden. Dazu wird bei der Herstellung ein Phosphorsilikatglas auf die Frontseite aufgebracht, das als P-Quelle für den Diffusionsprozess dient und danach abgeätzt wird. Sodann erfolgt eine Metallisierung mittels Leitpasten.

Auf der strahlseitigen, also sonnenzugewandten Seite, die bei einem p-leitenden Wafer die n-Schicht ist, werden zur Ausbildung eines Frontgitters zwei bis drei oder mehr Busbars sowie einzelne in etwa 100 µm breite Stromsammler - auch Finger genannt - aufgebracht. Dies kann durch Siebdruck, Fingerschreiben, galvanische Abscheidung oder Flammspritzen/Plasmaspritzen erfolgen. In erheblichem Umfang gelangt auch die Siebdrucktechnik zur Anwendung, bei der eine glashaltige Ag-Leitpaste aufgedruckt, getrocknet und sodann bei ca. 800 °C gesintert wird.

Auf der Rückseite, also der strahl- bzw. sonnenabgewandten Seite des Wafers, wird üblicherweise eine großflächige Aluminiumschicht als Rückkontakt aufgebracht. Beim Tempern des Aluminiums bei einer Temperatur von ca. 600 °C wird das Siliciumsubstrat an der Grenzfläche zwischen der Aluminiumschicht und dem Siliciumsubstrat aufgeschmolzen und mit dem Aluminium legiert. Beim Abkühlen erstarrt eine hoch mit Aluminium dotierte Siliciumschicht epitaktisch auf der dem Silicium zugewandten Rückseite des Wafers, also des Substrats. Gleichzeitig erstarrt eine mit Silicium angereicherte Al-Schicht auf der Aluminiumschicht zugewandten Seite und am Schluss des Abkühlvorgangs erstarrt ein Al-Si-Eutektikum zwischen der hoch mit Aluminium dotierten Schicht und der mit Silicium angereicherten Schicht.

Die hohe Al-Dotierung in Silicium induziert in unmittelbarer Nähe des Rückkontakts ein elektrisches Feld, das sogenannte Back-Surface-Field, welches die Minoritätsladungsträger im p-Gebiet, also die Elektronen vom Rückkontakt fernhält und einer Rekombination am ohmschen Rückkontakt entgegenwirkt. Infolgedessen ist eine gute Passivierung der Rückseite gegen Minoriätsladungsträger-Rekombinationen gegeben, so dass ein hoher Wirkungsgrad der Solarzelle erreichbar ist.

Um die erforderliche elektrische Kontaktierung durchzuführen, werden üblicherweise Kontaktleiterbahnen oder Lötpunkte direkt auf die Substratoberfläche durch Siebdruck, Tampondruck oder andere geeignete Druckverfahren aufgebracht und an diese die verzinnten Kupferbändern angelötet. Die Dimensionierungen entsprechender Lötpunkte, die auch als Pads bezeichnet werden, liegen zwischen 10 bis 20 mm x 6 bis 8 mm und weisen typischerweise eine Rechteck- oder Oval-Form auf.

Verbreitet ist der Siebdruck oder der Tampondruck von Leitpasten mit Glasanteilen. Diese werden zuerst gedruckt, sodann bei 200 bis 300 °C getrocknet und schließlich bei Temperaturen von mehr als 570 °C gesintert bzw. legiert.

Ein Verfahren zur Herstellung von Rückseitenkontaktsolarzellen mit einer Aluminiumschicht und in Ausnehmung dieser vorhandenen Ag-Pads ist der US-A-2008/0105297 zu entnehmen. Dort ist beschrieben, dass im gezielt gedruckten Überlappungsbereich zwischen der Aluminiumschicht und den Ag-Pads drei Metalle, nämlich Al, Ag und Si zusammenwirken. Hierdurch sollen mechanische Spannungen wegen der unterschiedlichen thermischen Ausdehnung der drei Komponenten entstehen, so dass im Überlappungsbereich das aufgedruckte Silber der Rückseiten-Pads abplatzt. Um diesen Nachteil zu vermeiden, sollen Ag-Pads mit abgerundeten und abgeschrägten Ecken verwendet werden, durch die die mechanischen Spannungsspitzen, die an Ecken auftreten, reduziert werden. Praktische Erprobungen diesbezüglicher Maßnahmen haben jedoch gezeigt, dass nicht im erforderlichen Umfang mechanische Spannungsspitzen reduziert werden, so dass weiterhin eine Beschädigung der Silberpads und damit die Gefahr einer Funktionsuntüchtigkeit einer entsprechenden die Pads aufweisenden Solarzelle besteht.

Aus der DE-A-10 2009 026 027 ist eine Wafer-Solarzelle bekannt, bei der zur Vermeidung einer Bruchgefahr des Wafers unterbrochene Busbars in der Rückseitenelektroden-Struktur derart ausgebildet werden, dass eine Überlappung der Pads entsprechend den unterbrochenen Busbars und der Rückseitenschicht unterbleibt. Da produktionstechnisch nicht sichergestellt ist, dass die Pads ausschließlich innerhalb der Ausnehmungen der Rückseitenschicht betrachtet in Längsrichtung der unterbrochenen Busbars einbringbar sind, wird vorgeschlagen, dass die Pads in Richtung des aufzulötenden Verbinders beabstandet zu der angrenzenden Schicht enden, wobei jedoch vorrangig eine Beabstandung ausschließlich zwischen den Kanten der Pads und der Schicht ausgebildet wird, ohne dass sich der Spalt bis zur Rückseite des Halbleitersubstrats erstrecken muss. Die Breite des Spalts im Bereich der Kanten sollte bevorzugterweise kleiner als 400 µm sein.

Gegenstand der JP-A-2003-273379 ist eine Solarzelle mit streifenförmigen Busbars, die im Überlappungsbereich mit der Rückseite der Solarzelle eine geringere Dicke als außerhalb des Überlappungsbereichs aufweisen.

Die US-A-2010/0200057 weist rückseitig streifenförmige Busbars mit Aussparungen auf.

Eine Leuchtdiode nach der US-A-2003/0025115 weist eine mit einem elektrischen Leiter verbindbare Pad-Elektrode und eine transluzente Elektrode auf. Erstere ist peripher strukturiert.

Die US-A-2010/000602 bezieht sich auf eine Solarzelle mit Kontaktfingern, zu denen quer Busbars verlaufen, die aus mehreren zueinander beabstandeten Abschnitten bestehen. Dabei sind zwei Kontaktfinger mit jeweils einem zwei Lötkanten aufweisenden Abschnitt des Busbars verbunden. Eine entsprechende Frontseitenkontaktausbildung findet sich bei der Solarzelle nach der EP-A-1 811 576.

Bei einer Soalrzelle nach der EP-A-1 936 699 erstreckt sich senkrecht zu Kontaktfingern ein Busbar, der bei durchgehender Ausbildung Ausschnitte aufweist. Hierdurch sollen bei unterschiedlichen Ausdehnungen von Busbar und Verbinder Beschädigungen der Solarzelle vermieden werden.

Der vorliegenden Erfindung liegt die Aufgabe zu Grunde, eine Solarzelle der eingangs genannten Art so weiterzubilden, dass bei auf den mit dem Busbar verbundenen Verbinder einwirkenden Kräften eine Rissbildung vermieden oder im Vergleich zum Stand der Technik zumindest reduziert wird.

Nach einem weiteren Aspekt soll ungeachtet der verwendeten unterschiedlichen Materialien zur Ausbildung des Rückseitenkontakts, also aufgrund der voneinander abweichenden Ausdehnungskoeffizienten, eine Beschädigung des Halbleitersubstrats, also des Wafers, unterbleiben, gleichzeitig jedoch eine sichere stoffschlüssige Verbindung zwischen den Verbindern und den Lötpunkten, also Pads, sichergestellt werden.

Zur Lösung der Aufgabe ist im Wesentlichen vorgesehen, dass der Abschnitt in Draufsicht eine ring- oder hohlrechteckförmige Geometrie zur Bildung von vier Lötkanten aufweist.

Abweichend von bekannten Konstruktionen weist der Busbar im Bereich der Frontseite der Solarzelle, also auf der strahlenzugewandten Seite, eine Vielzahl von Lötkanten auf, so dass dann, wenn Zugkräfte auf den Verbinder einwirken, eine Kraftverteilung mit dem Ergebnis erfolgt, dass die ansonsten auftretende Rissbildung reduziert bzw. vermieden wird.

Lötkante ist der Rand, entlang dem der Verbinder stoffschlüssig mit dem Abschnitt des Busbars verbunden ist. Üblicherweise ist der Verbinder in dessen Längsrichtung betrachtet über die gesamte Länge des Abschnitts mit diesem verbunden, so dass die Ränder der Abschnitte, die von dem Verbinder abgedeckt sind, auch Lötkanten sind.

Ergänzend oder alternativ schlägt die Erfindung vor, dass der Busbar aus zwei in dessen Längsrichtung verlaufenden streifenförmigen Abschnitten besteht, die im Bereich der Finger jeweils breitenmäßig erweitert und vorzugsweise stetig in den jeweiligen Längsrand der Finger übergehen.

Auch können Busbars in dessen Längsrichtung betrachtet aus mehreren zueinander beabstandeten Abschnitten bestehen, wobei jeder Abschnitt zumindest zwei Querlötkanten aufweist, also Lötkanten, die quer zur Längserstreckung des Busbars verlaufen. Es ergibt sich eine Geometrie einer Leiter mit Längs- und Querschenkeln.

Unabhängig hiervon sollte der Busbar derart in Abschnitte unterteilt sein, dass jeweils maximal fünf Kontaktfingern, vorzugsweise zwei Kontaktfingern zumindest zwei sich zumindest abschnittsweise entlang der Finger erstreckende Lötkanten zugeordnet sind.

Erfindungsgemäß wird der frontseitig verlaufende Busbar, der stoffschlüssig mit einem Zellenverbinder verbünden wird, in Abschnitte oder Bereiche derart unterteilt, dass sich eine Vielzahl von Lötkanten ergibt, die nicht zwingend senkrecht bzw. quer zur Längsrichtung des Busbars verlaufen müssen. Die Längsrichtung des Busbars wird dabei durch die Längserstreckung des Verbinders entlang des Busbars vorgegeben.

Die Lötkante selbst muss nicht zwingend ausschließlich quer zu der Längsrichtung des Busbars, also entlang bzw. parallel zu den Kontaktfingern verlaufen. Vielmehr kann auch ein schräg zu den Kontaktfingern verlaufender Bereich eines Abschnitts des Busbars eine Lötkante bilden, insbesondere dann, wenn der Busbar im Bereich eines Kontaktfingers verbreitert ist und die Längskanten von Busbar und Kontaktfinger stetig ineinander übergehen, also sich ein konkav verlaufender Längsrand des Busbar-Abschnitts als die Lötkante ergibt.

Zur Lösung des weiteren Aspekts der Erfindung, soweit der Rückseitenkontakt betroffen ist, wird erfindungsgemäß im Wesentlichen vorgeschlagen eine Solarzelle, die ein Halbleitersubstrat mit Front- und Rückseitenkontakt aufweist, wobei der Rückseitenkontakt eine aus einem ersten elektrisch leitenden Material bestehende oder enthaltende Schicht mit Aussparungen aufweist, in denen Lötpunkte (Pads) angeordnet sind, die aus einem zweiten elektrisch leitenden Material bestehen, das im Kontaktbereich mit dem ersten elektrisch leitenden Material eine intermetallische Verbindung bildet, wobei in zumindest zwei Aussparungen angeordnete Lötpunkte mit einem entlang einer Geraden verlaufenden Verbinder in jeweils einem Lötbereich eines jeden Pads verbunden sind und sich der Verbinder im Abstand zu der Schicht über Lötkanten des Lötpunkts erstreckt, wobei sich die Solarzelle dadurch auszeichnet, dass der Verbinder mit den Lötpunkten ausschließlich außerhalb der intermetallischen Verbindung stoffschlüssig verbunden ist und/oder dass der Verbinder sich über zumindest drei quer zu der Geraden verlaufenden Lötkanten des Lötpunkts erstreckt, wobei die zumindest drei Lötkanten eine von dem Verbinder abgedeckte Länge aufweisen, die zumindest 2,5-fache, vorzugsweise 3-fache Breite B des Verbinders ist.

Insbesondere sieht die Erfindung vor, dass eine erste Lötkante ein von der Geraden geschnittener erster Randbereich des Pads ist, der beabstandet zu der Schicht wie Al-Schicht bzw. deren von dem Verbinder abgedeckten Schichtkante verläuft, wobei insbesondere jeder erste Randbereich des Pads beabstandet zur jeweiligen von dem Verbinder abgedeckten Schichtkante verläuft. Die Gerade wird durch die Längsachse des Verbinders vorgegeben.

Ferner sollte der erste Randbereich zumindest im Lötbereich einen geometrischen Verlauf aufweisen, der von dem der zugewandten Schichtkante, also Kante der Rückseitenschicht, die insbesondere aus Al besteht, abweicht, über die sich der Verbinder erstreckt.

Die erfindungsgemäße Lehre nutzt u. a. die Kenntnisse der Erfinder, die mittels metallografischer Methoden festgestellt haben, dass ausschlaggebend für das Auftreten hoher mechanischer Spannungen im Überlappungsbereich zwischen den Pads und der angrenzenden Schicht des Rückkontaktes der Legierungsprozess zwischen den Materialien, also Al und lötbares Kontaktmaterial, und nicht das Zusammentreffen der Materialien Ag, Al und Si verantwortlich ist, wie dies in der US-A-2008/0105297 beschrieben ist.

Beim Sintern legieren Aluminium und Silber in dem Überlappungsbereich der Pads. Zuerst schmilzt Aluminium und fließt sodann in die poröse Ag-Schichtstruktur. In-situ-Beobachtungen haben gezeigt, dass durch das Ausfließen flüssigen Aluminiums ein etwa 1 bis 2 mm breiter Legierungsstreifen entsteht. Dieser erstarrt nach dem Abkühlen gemäß Phasendiagramm als eine intermetallische Verbindung (ζ - Phase, µ-Phase), die auch noch Anteile von elementarem Al, Ag und eventuell Si enthält. Die Breite des Streifens hängt dabei von den Mengenanteilen Al und Ag ab, d. h. auch von der Schichtdicke und der Porosität des Silbers. Infolgedessen ist die Zahlenangabe für a (Abstand Kante des ersten Randbereichs des Pads zur zugewandten Kante des Verbinders) entsprechend auszulegen, da die Zonen auch breiter oder schmaler ausfallen können.

Aus diesem Grund ist es nicht ohne Weiteres möglich, Ag-Kontakte direkt auf das Aluminium aufzudrucken, ohne dass während des Sinterns eine intermetallische Verbindung der oben beschriebenen Art gebildet wird.

Der Überlappungsbereich, der im eigentlichen Sinne ein Durchdringungsbereich ist, übt eine hohe mechanische Spannung auf den Wafer aus. Mit Mikro-Ramanspektroskopie wurden bis zu 350 MPa gemessen. Eine mögliche Erklärung für die auftretende Spannung ist, dass die Al-Ag-Legierung bei Weitem nicht so duktil wie die elementaren Schichten ist. Ferner ist zu berücksichtigen, dass der gesamte Prozess in wenigen Sekunden abläuft, so dass noch während der Legierungsbildung der Al/Ag-Legierung der Abkühlprozess ausgeführt wird. Infolgedessen können Mikrorisse auftreten, die parallel zu der Überlappungszone ausgerichtet sind. Spannungsrisse treten jedoch zusätzlich noch aus dem Grund auf, wenn die entsprechenden vorgespannten Gebiete mechanisch belastet werden, sei es, wenn ein angelöteter Verbinder an dieser Stelle endet, oder wenn in einem Temperaturzyklus eine mechanische Spannung durch Biegung an der Zelle auftritt.

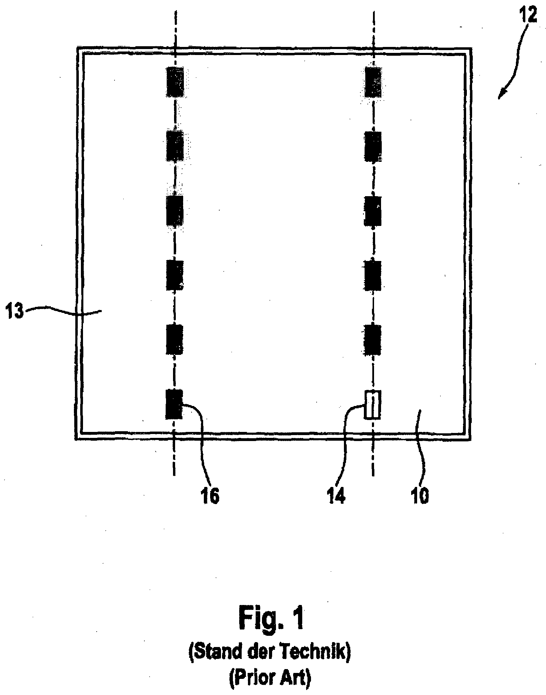

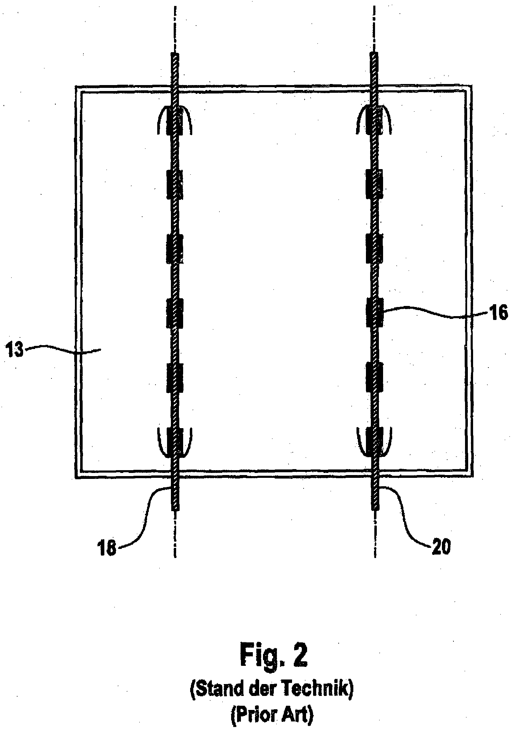

Untersuchungen haben ergeben, dass an beiden Enden angelöteter Kupferverbinder Mikrorisse auftreten können, die durch Zugspannung entstehen, und durch Form und Richtung eindeutige Hinweise auf ihre Entstehungsursache bieten. Dies sei anhand der Fig. 1 und 2 erläutert, die einen Rückkontakt 10 einer Solarzelle 12 darstellen, die eine die Solarzelle 12 rückseitig abdeckende und aus Aluminium bestehende oder Aluminium enthaltende Schicht 13 mit Aussparungen 14 aufweist, die von vorzugsweise eine Rechteckform aufweisenden Pads 16 durchsetzt sind. Insoweit handelt es sich um eine Solarzellen-Rückseite vorbekannter Konstruktion, also nach dem Stand der Technik.

Werden die in Reihen angeordneten Pads 16 mit Kupferverbindern 18, 20 stoffschlüssig verbunden (Fig. 2), so konnte festgestellt werden, dass jeweils an den Enden der Lötung, also den stoffschlüssigen Verbindungen quer zur Längsrichtung der Verbinder 18, 20 gekrümmte quer zur auftretenden mechanischen Zugkraft verlaufende Risse entstehen. Da sich beim Abkühlen nach dem Löten der Kupferverbinder 18, 20 stärker zusammenzieht als das Silicium, ist mit dünner werdenden Wafern zunehmend diese Art der Rissbildung zu beobachten. Gelegentlich treten ähnliche Zugspannungsrisse auch an weiter innenliegenden Pads auf.

Besonders stark aber treten diese Risse dann auf, wenn die Lötung bis in den Überlappungsbereich reicht, d. h. zu der Spannung, die durch die intermetallische Legierung erzeugt wird, wird die Zugspannung des Verbinders hinzuaddiert.

Aufgrund der erfindungsgemäßen Lehre werden die diesbezüglichen Nachteile vermieden. So wird eine mechanische Entlastung und damit die Vermeidung einer Rissbildung u. a. dadurch erzielt werden, dass die durch den Verbinder erzeugte mechanische Zugkraft auf eine größere Linie verteilt und somit eine geringere Spannung erzeugt wird. Wird die Spannung z. B. auf 10 Lötkanten verteilt, so reduziert sich die Spannung pro Lötkante um den Faktor 10. Dies führt zu einer geringeren Belastung des Materials.

Erfindungsgemäß ist insbesondere vorgesehen, dass die den ersten Randbereich begrenzende Lötkante zumindest im Lötbereich in Bezug auf zugewandte Kante der Schicht einem konvex- oder konkavförmigen Bogenabschnitt folgt. Insbesondere ist vorgesehen, dass das Pad aus ineinander übergehenden linsenförmigen oder in Draufsicht ovalförmigen Abschnitten besteht, deren Längsachsen entlang der von den Verbindern vorgegebenen Geraden verlaufen, wobei jeweilige Kante des zweiten Randbereichs eine V-Geometrie mit gekrümmt verlaufenden Schenkeln aufweist. Hierdurch werden der Kontaktbereich zwischen dem Verbinder und dem Pad im Bereich der Kante im Vergleich zu Pads, die eine Rechteck- oder Kreisgeometrie aufweisen, erheblich vergrößert und somit mögliche auftretende Spannung erheblich reduziert.

Durch Abrundungen des Silber-Pads im Bereich der Lötkanten entsprechend der üblicherweise sich ergebenden Rissform kann die mechanische Zugkraft auf eine größere Linie übertragen werden. Dabei wird eine abgerundete Form das Ag-Pads derart hergestellt, dass dieser mit der aus Aluminium bestehenden oder Aluminium enthaltenden Schicht nicht in Kontakt gelangt. Die Zugspannung lässt sich entsprechend dem Verhältnis der berührenden Seitenlängen reduzieren.

Ferner kann die zum Abführen des Stroms aus der flächigen Schicht wie Al-Schicht in die Pads, wie Ag-Pads, erforderliche Berührungslinie zwischen dem Pad und der Schicht auf Bereiche verlagert werden, in denen nach der Lötung keine mechanische Spannung zum angelöteten Verbinder erzeugt wird. Durch die Reduzierung des Kontaktes im Pad und der Rückseitenschicht kann zwar der elektrische Übergangswiderstand etwas erhöht werden. Durch Optimierung der Länge der Berührungslinie können jedoch die diesbezüglichen ggfs. auftretenden Nachteile minimiert werden.

In Weiterbildung ist vorgesehen, dass das Pad in seinem jeweiligen ersten Randbereich in Bezug auf die angrenzende Rückseitenschicht eine konkav verlaufende Bogengeometrie und/oder in seinem jeweiligen ersten Randbereich eine konvex verlaufende Bogengeometrie aufweist, betrachtet jeweils in Bezug auf den angrenzenden bzw. beabstandet verlaufenden Schichtbereich der Rückseite.

Das Pad kann in Draufsicht auch eine Rechteckgeometrie aufweisen, wobei jeweilige Kante des zweiten Randbereichs und zugewandter Kante der Schicht jeweils eine konkav verlaufende Bogengeometrie aufweisen.

Zur Reduzierung der Zugspannung ist nach einer weiteren Ausgestaltung vorgesehen, dass das Pad in seinem Lötbereich rechteck-, kreis- oder ovalförmige Aussparungen aufweist, die zumindest bereichsweise bei aufgelötetem Verbinder von diesem abgedeckt sind, wobei insbesondere die kreisförmige Aussparung vollständig und/oder die mit seiner Längsachse quer zur Längsachse des Verbinders verlaufende ovalförmige Aussparung vorzugsweise ausschließlich bereichsweise, also nicht vollständig von dem Verbinder abgedeckt ist.

Insbesondere ist vorgesehen, dass das in der Aussparung angeordnete Pad zumindest in von dem Verbinder abgedecktem Bereich der Aussparung aus zumindest zwei zueinander beabstandeten Abschnitten besteht, wobei jeder Abschnitt zwei Lötkanten aufweisen sollte. Die von den zueinander beabstandeten Abschnitten ausgehenden einander zugewandten Lötkanten können auch ineinander übergehen, so dass die Lötkanten der Abschnitte im eigentlichen Sinne Abschnitte einer durchgehenden Lötkante sind.

In Weiterbildung ist des Weiteren vorgesehen, dass die Abschnitte in der Aussparung vollständig beabstandet zueinander angeordnet sind, also voneinander getrennt sind. Mit anderen Worten verlaufen zumindest zwei, vorzugsweise mehr als zwei streifenförmige Lötbereiche innerhalb einer Aussparung, wobei die streifenförmigen Lötbereiche beabstandet zueinander angeordnet sind. Die beabstandeten Lötbereiche bilden somit den Lötpunkt an sich. Ferner sollten die außen liegenden streifenförmigen Lötbereiche beabstandet zu den Schichtkanten verlaufen, die von dem Verbinder überdeckt werden.

Das Entstehen von Rissen wird insbesondere dadurch unterbunden bzw. reduziert, dass Überlappungszonen in Bereichen ausgeschlossen werden, in denen eine unmittelbare stoffschlüssige Verbindung zwischen dem Verbinder und dem Pad erfolgt, d. h. in den Rand- bzw. Löt-Kantenbereichen der Pads, über die sich der Verbinder erstreckt, also in den quer zu den zweiten Randbereichen, in denen die intermetallischen Verbindungen entstehen, verlaufenden ersten Randbereichen. Daher ist erfindungsgemäß insbesondere vorgesehen, dass in den ersten Randbereichen eine Beabstandung zwischen den einander zugewandten Kanten von Pad und der diese umgebenden Schicht erfolgt, also ein Spalt ausgebildet wird, der zumindest im Bereich zwischen 0,5 mm und 10 mm liegen sollte.

Die Beabstandung zwischen der Lötkante und der Schichtkante kann durch ein spezielles Druckdesign erzielt werden.

Aus den erfindungsgemäß vorgeschlagenen Geometrien der Pads ergibt sich des Weiteren der Vorteil, dass dann, wenn als zweites elektrisch leitendes Material Leitsilber oder ein Silber enthaltendes Material verwendet wird, eine Materialeinsparung von Silber erfolgt, wodurch die Herstellungskosten erfindungsgemäß ausgebildeter Solarzellen reduziert werden.

Ferner sieht die Erfindung vor, dass der Lötbereich, in dem der Verbinder mit dem Pad stoffschlüssig verbunden ist, beabstandet zu den Bereichen verläuft, in dem die intermetallische Verbindung (Legierung) gebildet wird, also in Bezug auf den Verbinder, in den parallel zu diesem verlaufenden Randbereichen der Pads. Dabei ist insbesondere vorgesehen, dass der Lötbereich zu jeweiliger Längskante, also dem jeweiligen zweiten Randbereichs des Pads, einen Abstand a mit 0,5 mm ≤ a ≤ 2 mm, insbesondere 0,5 mm ≤ a ≤ 1 mm aufweist.

Weitere Einzelheiten, Vorteile und Merkmale der Erfindung ergeben sich nicht nur aus den Ansprüchen, den diesen zu entnehmenden Merkmalen - für sich und/oder in Kombination-, sondern auch aus der nachfolgenden Beschreibung von der Zeichnung zu entnehmenden Ausführungsbeispielen.

Es zeigen:
- Fig. 1: eine Rückseitenansicht einer Solarzelle nach dem Stand der Technik ohne Verbinder,
- Fig. 2: die Solarzelle gemäß Fig. 1 mit Verbindern,
- Fig. 3: einen Ausschnitt einer Solarzelle mit einem mit einem Pad verbundenen Verbinder,
- Fig. 4: einen Ausschnitt einer Solarzelle mit einer zweiten Ausführungsform eines Rückseitenkontakts,
- Fig. 5: einen Ausschnitt einer Solarzelle mit einer dritten Ausführungsform eines Rückseitenkontakts,
- Fig. 6: einen Ausschnitt einer Solarzelle mit einer vierten Ausführungsform eines Rückseitenkontaktes,
- Fig. 7: einen Ausschnitt einer Solarzelle mit einer fünften Ausführungsform eines Rückseitenkontakts,
- Fig. 8: einen Ausschnitt einer Solarzelle mit einer sechsten Ausführungsform eines Rückseitenkontakts,
- Fig. 9: einen Ausschnitt einer Solarzelle mit einer siebten Ausführungsform eines Rückseitenkontaktes,
- Fig. 10: einen Ausschnitt einer Solarzelle mit einer achten Ausführungsform eines Rückseitenlcontaktes,
- Fig. 11: einen Ausschnitt einer Solarzelle mit einer neunten Ausführungsform eines Rückseitenkontaktes,
- Fig. 12: einen Ausschnitt einer Solarzelle mit einer zehnten Ausführungsform eines Rückseitenkontaktes,
- Fig. 13: eine Draufsicht auf einen Frontseitenkontakt,
- Fig. 14: eine weitere Ausführungsform eines Frontseitenkontakts,
- Fig. 15: eine dritte Ausführungsform eines Frontseitenkontakts,
- Fig. 16: eine vierte Ausführungsform eines Frontseitenkontakts und
- Fig. 17a) bis 17c): eine weitere Ausführungsform eines Frontseitenkontaktes.

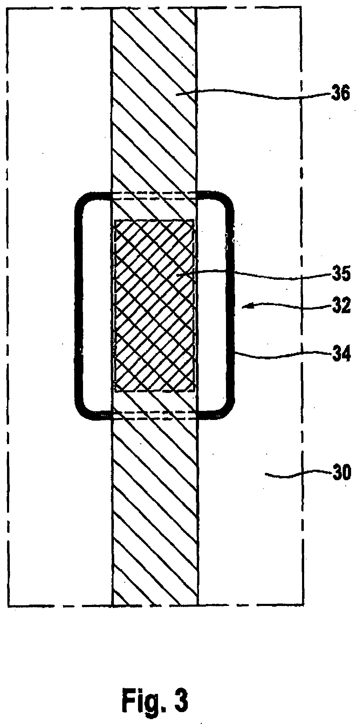

Den Fig. 3 bis 12 sind Rückseitenausschnitte von kristallinen Siliciumsolarzellen zu entnehmen, die aus einem p-Siliciumsubstrat mit pn-Übergang bestehen und deren Frontseitenkontakte in Form eines Frontgitters mit Busbars und fingerartigen Stromsammlern ausgebildet sind. Der jeweilige Rückseitenkontakt wird durch Sintern einer Aussparungen aufweisenden Aluminiumschicht und in den Aussparungen eingebrachte Lötpunkte oder Pads gebildet, die aus Silber bestehen bzw. Silber enthalten können.

Wird die Rückseitenschicht als Aluminiumschicht bezeichnet, so kann auch ein anderes Material wie ein solches aus der Gruppe In, Ga, B oder Mischungen dieser verwendet werden. Insoweit ist Aluminium als Synonym zu verstehen. Gleiches gilt in Bezug auf Silber, das durch ein anderes geeignetes lötbares Material ausgetauscht werden kann, ohne dass die Erfindung verlassen wird.

Um die Ausbildung von Rissen in dem Siliciummaterial durch von mit den Pads stoffschlüssig verbundenen Verbindern auszuschließen, werden entsprechend den Erläuterungen zu den Figuren Pads spezieller Geometrie in die Ausnehmungen eingebracht, wobei der Lötbereich, in dem der Verbinder mit den Pads verbunden ist, beabstandet zu der beim Tempern und damit Herstellen des Rückseitenkontakts bestehend aus der Aluminiumschicht und den Silberpads sich ausbildenden Legierung verläuft bzw. Verbinder mit den Pads in Bereichen verbunden sind, in denen die Pads mit der Aluminiumschicht nicht kontaktiert sind. Dabei werden bei den nachstehenden Erläuterungen grundsätzlich gleiche Elemente mit gleichen Bezugszeichen versehen.

Der Fig. 3 ist ein Ausschnitt einer Rückseite einer Solarzelle in prinzipieller Darstellung zu entnehmen, die eine aus Aluminium bestehende Rückseitenschicht 30 mit Aussparungen aufweist, in denen insbesondere aus Silber bestehende Lötpunkte oder Pads 32 in einer Reihe angeordnet sind, um die Pads 32 mit einem Verbinder 36 stoffschlüssig zu verbinden.

Im Übergangsbereich zwischen den Pads 32 und der Schicht 30 bildet sich eine intermetallische Verbindung (Bereich 34). Um eine Rissbildung zu vermeiden, die durch eine stoffschlüssige Verbindung zwischen dem Verbinder 36 und dem die Legierung aufweisenden Bereich 34 entstehen würde, ist erfindungsgemäß vorgesehen, das der Verbinder 36 ausschließlich mit dem Pad 32 außerhalb des Bereichs 34 der intermetallischen Verbindung stoffschlüssig verbunden ist. Dieser Bereich ist in Fig. 3 durch eine Kreuzschraffur und mit dem Bezugszeichen 35 gekennzeichnet.

Der Bereich, in dem eine intermetallische Verbindung nicht mehr vorhanden ist, also der Bereich, mit dem der Verbinder 36 stoffschlüssig verbunden ist, kann aufgrund von Spannungsmessungen bzw. Schliffbildern erfasst werden, wie dies zuvor erläutert worden ist. Somit ist erkennbar, wo der Bereich der intermetallischen Verbindungen endet. Grundsätzlich kann in diesem Zusammenhang festgestellt werden, dass in dem Bereich, in dem Aluminium nicht mehr auftritt, intermetallische Verbindungen dem Grunde nach nicht mehr vorhanden sind, so dass von diesem Bereich beginnend die stoffschlüssige Verbindung zwischen dem Verbinder 36 und dem Pad 32 erfolgen kann, um die unerwünschten Rissbildungen zu vermeiden.

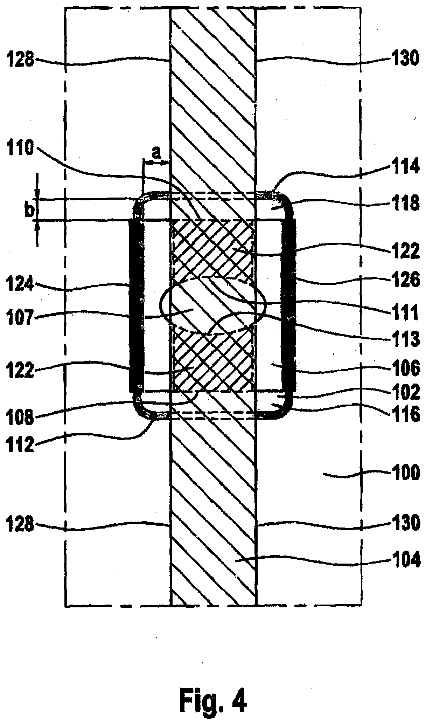

In Fig. 4 ist ein Ausschnitt einer Rückseite einer Solarzelle dargestellt, bei der in einer Rückseiten- wie Aluminiumschicht 100 ebenfalls mehrere Aussparungen 102 ausgebildet sind, von denen eine dargestellt ist. Mehrere entsprechende Aussparungen 102 sind dabei gleichfalls entlang einer Geraden angeordnet, entlang der sich ein Verbinder 104 erstreckt, der mit den entlang der Geraden verlaufenden Lötpunkten 106 stoffschlüssig verbunden wird. Die Lötpunkte werden nachstehend als Pads bezeichnet. Der Verbinder 104 kann ein verzinntes Kupferbändchen sein.

Wie die Fig. 4 verdeutlicht, verläuft das Pad 106 in Längsrichtung des Verbinders 104 mit seinen Lötkanten 108, 110 beabstandet zur zugewandten Schichtkante 112, 114 der Aussparung 102. Die Lötkanten 108, 110 begrenzen den sogenannten ersten Randbereich des Pads 106, über den sich der Verbinder 104 erstreckt. Mit anderen Worten verläuft ein Spalt 116, 118 zwischen den Kanten 108, 112 und 110, 114, der sich grundsätzlich bis zum Siliciumsubstrat erstreckt.

Des Weiteren verläuft der Verbinder 104 und damit der von diesem abgedeckte Lötbereich 122 des Pads 106 beabstandet zum jeweiligen Längs- bzw. zweiten Randbereich 124, 126, in dem das Pad 106 mit der Aluminiumschicht 100 kontaktiert ist bzw. diese ggf. randseitig überlappt. Der entsprechende Längsrandbereich 124, 126, der in der Figur vom Mittenbereich des Pads 106 zeichnerisch abgehoben ist, besteht aus einer intermetallischen Verbindung, also Legierung, aus Aluminium und Silicium. Zu diesem Bereich 124, 126 verläuft beabstandet der Lötbereich 122 des Pads 106 und damit der Verbinder 104. Der Abstand zwischen dem zugewandten Längsrand 128, 130 des Verbinders 104 und dem zugewandten Ende des Randbereichs 124, 126, d. h., die Aluminium-Silicium-Legierung ist in der Figur mit a gekennzeichnet und liegt zwischen 0,5 mm und 5 mm.

Die Breite des jeweiligen Spalts 116, 118 ist mit b gekennzeichnet und sollte zwischen 0,5 mm und 10 mm liegen, dem Abstand zwischen jeweiligem Längsrand 128, 130 des Ver-binders 104 und dem Randbereich 124, 126 des Pads 106.

Nach dem Ausführungsbeispiel der Fig. 4 verläuft die Lötkante 108, 110 des Pads 106 parallel zur Schichtkante 112, 114 der Aussparung 118. Hierdurch ist zwar die mechanische Belastung des Ag/Al-Legierungsbereichs ausgeschlossen, jedoch können bei auf den Ver-binder 104 einwirkenden Zugkräften hohe Spannungen in dem Pad 106 aufgebaut werden, die dazu führen können, dass Risse in dem Substrat entstehen. Um die möglicherweise auftretenden Zugkräfte auf eine größere Linie zu übertragen, wodurch die Spannungen reduziert werden, weist das Pad 106 mindestens eine Aussparung 107 auf, über die sich der Verbinder 104 erstreckt, so dass dieser insgesamt vier Lötkanten bedeckt, wodurch die Zugkräfte auf eine größere Linie übertragen werden. Die entsprechenden Lötkanten sind mit den Bezugszeichen 108, 110, 111, 113 gekennzeichnet.

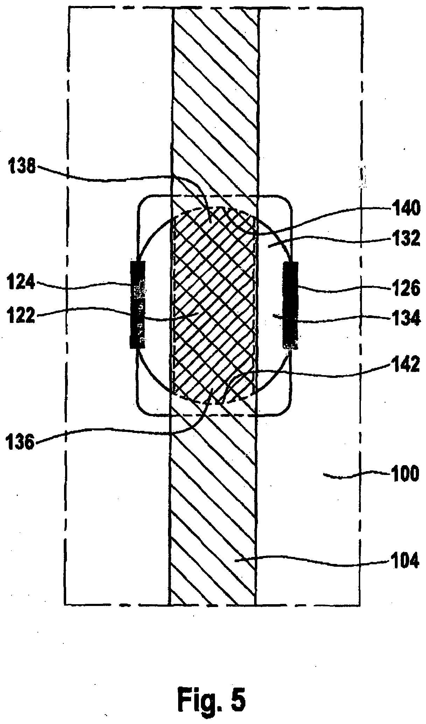

Der Fig. 5 ist ein Pad 132 zu entnehmen, das sich aus einem mittleren rechteckförmigen Mittenbereich 134, der mit der Aluminiumschicht 100 kontaktiert ist bzw. überlappend zu dieser verläuft, und aus endseitigen kreisabschnittförmigen Abschnitten 136, 138 zusammensetzt. Infolgedessen sind die Abschnitte 136, 138 begrenzende Lötkanten 140, 142, über die sich der Verbinder 104 erstreckt und von diesen ausgehend der Verbinder 104 mit dem Lötbereich 122 des Pads 132 stoffschlüssig verbunden ist, geometrisch derart ausgebildet, dass sich eine konvex verlaufende Bogenform ergibt. Die Gesamtlänge der Lötkanten 140, 142 ist aufgrund der Geometrie derart gewählt, dass die von dem Verbinder 104 abgedeckte Länge der Lötkanten 140, 142 zumindest der 2,5-fachen, vorzugsweise zumindest der dreifachen Breite B des Verbinders 104 entspricht, gleichwenn dies zeichnerisch nicht zwingend erkennbar ist.

Unabhängig hiervon verläuft der Verbinder 104 gleichfalls beabstandet zu den ersten oder Längsrandbereichen 124, 126, in denen die Legierung zwischen Aluminium und Silicium ausgebildet ist.

Insbesondere anhand des Ausführungsbeispiels der Fig. 5 wird auch erkennbar, dass die Erfindung dann nicht verlassen wird, wenn der Verbinder 104 nur zwei Lötkanten 140, 142 des Pads 132 überdeckt, sofern der Verbinder 104 mit dem Pad 132 außerhalb der intermetallischen Verbindungen, also außerhalb der Längsrandbereiche 124, 126, stoffschlüssig verbunden ist.

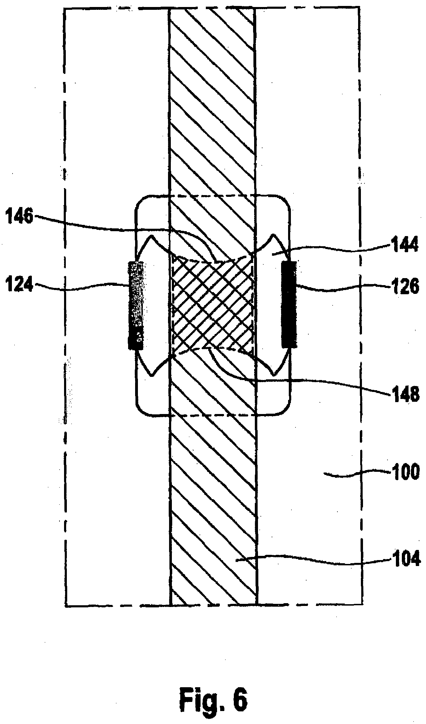

Nach dem Ausführungsbeispiel der Fig. 6 weist ein Pad 144 in Draufsicht eine "Hundeknochenform" auf, wobei die Lötkanten, über die sich der Verbinder 104 erstreckt, eine konkav verlaufende Bogenform aufweisen. Die entsprechenden Lötkanten sind mit den Bezugszeichen 146, 148 gekennzeichnet. Die an den Lötkanten 146, 148 angrenzenden Seitenabschnitte des Pads 144 sind konvex bogenförmig verlaufend und gehen in die geradlinig verlaufenden zweiten Randbereiche 124, 126 über. Gleichfalls ist die Länge des Abschnitts der Lötkanten 146, 148 in Bezug auf die Breite B des Verbinders 104 derart ausgelegt, dass erstere zumindest der 2,5-fachen, vorzugsweise zumindest der dreifachen Breite B des Verbinders 104 entspricht.

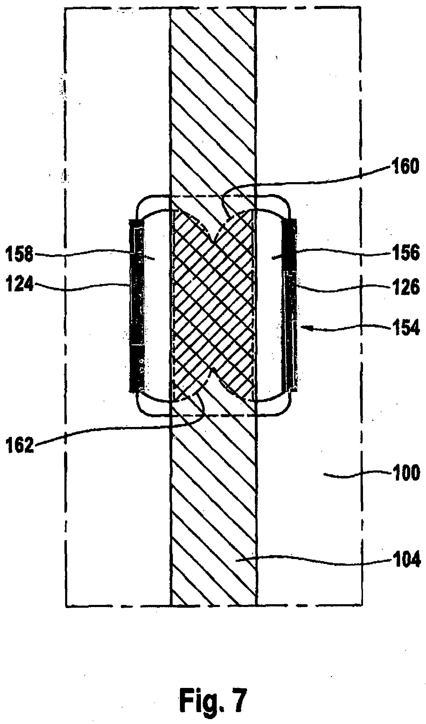

Nach dem Ausführungsbeispiel der Fig. 7 besteht ein Pad 154 aus zwei ineinander übergehende linsenförmige bzw. in Draufsicht ovalen Abschnitten 156, 158, die in ihren sich entlang der Längsachse des Verbinders 104 erstreckenden Randbereichen geradlinig verlaufen. In diesen Bereichen bilden sich die Legierungen aus, so dass die entsprechenden Randbereiche mit den Bezugszeichen 124, 126 gekennzeichnet sind.

Durch das Überlappen der Abschnitte 156, 158 ergeben sich von dem Verbinder 104 überdeckte stirnseitige Lötkanten 160, 162, die in Draufsicht eine V-Form mit konvex verlaufenden Schenkeln aufweisen.

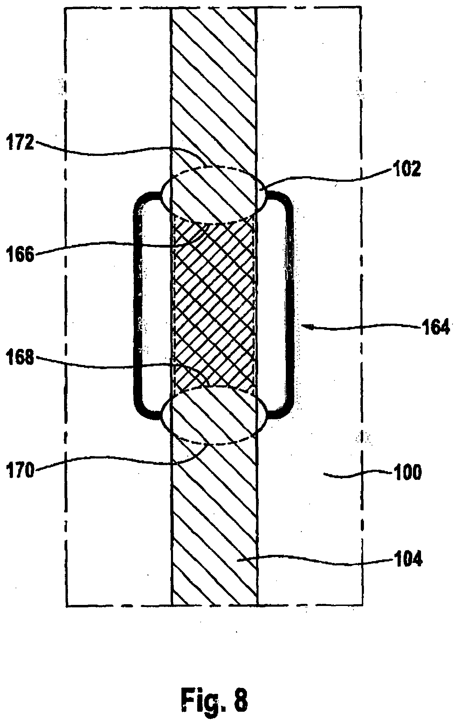

Das Ausführungsbeispiel der Fig. 8 vermittelt die Geometrie eines Pads 164, das eine Rechteckform aufweist und im Wesentlichen die Aussparung 102 mit Ausnahme der zweiten Randbereiche ausfüllt, die von dem Verbinder 104 überdeckt werden. In diesen Bereichen weist das Pad 164, d. h. dessen erste Randbereiche, also Lötkanten 166, 168, einen konkav bogenförmigen Verlauf einer Gesamtlänge in Bezug auf den von dem Verbinder 104 abgedeckten Bereich auf, der zumindest der 2,5-fachen, vorzugsweise zumindest der dreifachen Breite B entspricht.

Zur Vergrößerung des Abstands des Pads 164 zu der Rückseitenschicht 100 im Bereich des Verbinders 104 ist diese in ihren den Lötkanten 166, 168 des Pads 164 zugewandten Randbereichen ebenfalls derart ausgebildet, dass sich jeweils eine konkav bogenförmige Schichtkante 170, 172 ergibt. Infolgedessen überdeckt der Verbinder 104 einen Spalt, der in Draufsicht eine ellipsenförmige Geometrie aufweist.

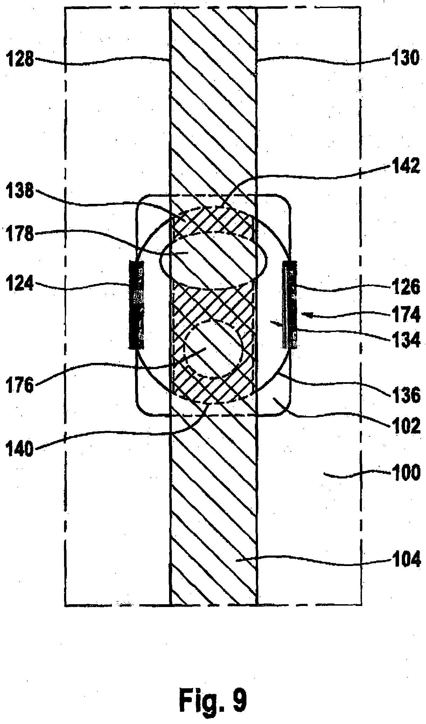

Um eine weitere Reduzierung einer möglicherweise über den Verbinder 104 auf ein Pad 174 einwirkenden Zugkraft zu reduzieren, sieht das Ausführungsbeispiel der Fig. 9 vor, dass das Pad 174 Aussparungen 176, 178 aufweist, die beispielhaft in Draufsicht eine Kreisgeometrie bzw. Ellipsengeometrie aufweisen. Die Lötkanten, die die Aussparungen 176, 178 begrenzen, sind in der Zeichnung gestrichelt dargestellt. Die Längsachse der die Ellipsengeometrie aufweisenden Aussparung 178 verläuft dabei quer zur Längsachse des Verbinders 104. Aus der zeichnerischen Darstellung wird des Weiteren erkennbar, dass das Pad 174 entsprechend dem Ausführungsbeispiel der Fig. 5 aus einem rechteckförmigen Mittelabschnitt 134 und kreisabschnittförmigen Endabschnitten 136, 138 zusammengesetzt ist, wobei die Lötkanten 140, 142 der Endabschnitte 136, 138 beabstandet zu den zugewandten Schichtkanten der Aussparung 102 verlaufen, wie die zeichnerische Darstellung vermittelt.

Die zweiten Randbereiche 124, 126 bzw. Längsrandbereiche des Pads 174 verlaufen beabstandet zu den Längskanten bzw. Rändern 128, 130 des Verbinders 104.

Aus der Zeichnung ergibt sich des Weiteren, dass die kreisförmige Aussparung 176 vollständig und die ellipsenförmige Aussparung 178 im Mittenbereich von dem Verbinder 104 abgedeckt sind.

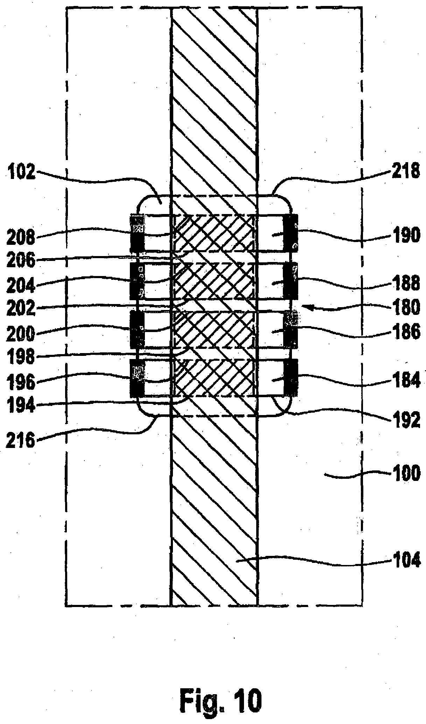

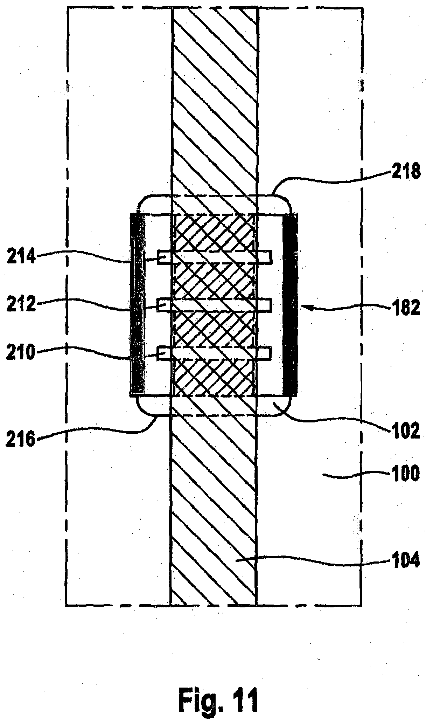

Weitere Ausführungsformen von Pads 180, 182 sind den Fig. 10 und 11 zu entnehmen. Dabei besteht das Pad 180 gemäß Fig. 10 aus zueinander beabstandeten streifenförmigen Abschnitten 184, 186, 188, 190, so dass der Verbinder 104 folglich insgesamt acht Lötkanten 194, 196, 198, 200, 202, 204, 206, 208 überdeckt. Hierdurch werden auftretende Zugkräfte derart verteilt, dass Rissbildungen vermieden werden und ein Lösen des Pads 180 bzw. dessen Streifens 184, 186, 188, 190 unterbleibt. Bei dem Ausführungsbeispiel der Fig. 11 weist das Pad 182 drei rechteckförmige Aussparungen 210, 212, 214 auf, so dass der Verbinder 104 gleichfalls acht Lötkanten überdeckt, die nicht näher gekennzeichnet sind.

Unabhängig hiervon verlaufen die Pads 180, 182 mit ihren jeweils äußersten Lötkanten 194, 208 beabstandet zu den Schichtkanten 216, 218, die von dem Verbinder 104 überdeckt werden.

Durch die diesbezügliche Geometrie ergibt sich der Vorteil eines guten elektrischen Kontaktes zur Aluminiumschicht 100.

Durch eine entsprechende Ausbildung der Pads 180, 182 - wie bei den zuvor erläuterten erfindungsgemäßen Pads - ergibt sich zudem der Vorteil, dass die Menge an zu verwendetem Pad-Material im Vergleich zu bekannten Anordnungen reduziert wird. Dies ist insbesondere dann von Vorteil, wenn Silber als Pad-Material benutzt wird.

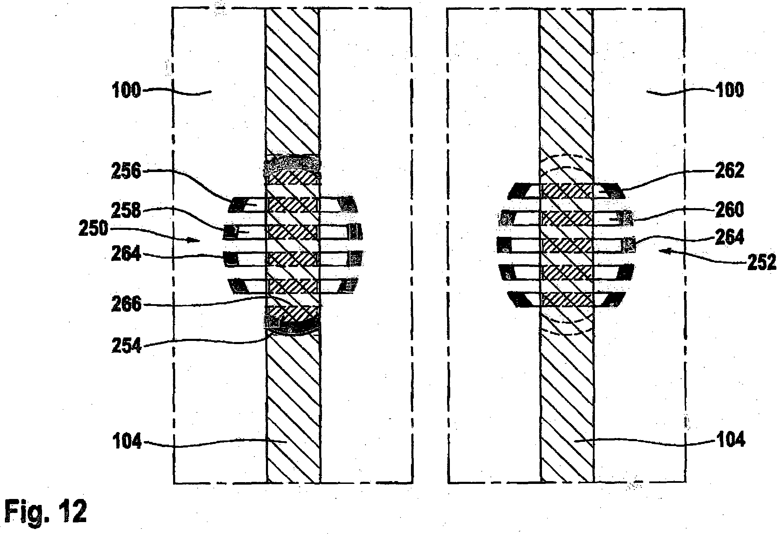

Der Fig. 12 sind weitere bevorzugte Ausführungsformen von Pads 250, 252 zu entnehmen, die aus beabstandet zueinander verlaufenden Streifen bestehen, die umfangsseitig eine Geometrie eines Ovals bilden. Einige der Streifen sind beispielhaft mit den Bezugszeichen 254, 256, 258 bzw. 260, 262 gekennzeichnet. Die Streifen verlaufen quer bzw. senkrecht zu dem Verbinder 104. Der intermetallische Bereich ist durch Schwärzung gekennzeichnet. Dieser Bereich wird durch den Kontakt der Padstreifen mit dem Aluminium gebildet. Die nicht in dem intermetallischen Bereich verlaufenden stegförmigen Abschnitte oder Streifen 256, 258, 260, 262 weisen jeweils zwei Lötkanten auf, so dass entsprechend der erfindungsgemäßen Lehre eine Kraftverteilung erfolgt, wenn auf die Verbinder 104 Zugkräfte einwirken. Ferner verläuft der Verbinder 104 in der linken Darstellung der Fig. 12 über padinnenseitig verlaufenden Lötkanten 266 der streifenförmigen Abschnitte 254, die unmittelbar in die die intermetallische Verbindung aufweisenden Randbereiche des Pads 250, 252 übergehen. Im Ausführungsbeispiel der rechten Darstellung in Fig. 12 laufen demgegenüber sämtliche streifenförmigen und senkrecht zur Längsachse des Verbinders 104 verlaufenden Abschnitte 260, 262 des Pads 252 in den Bereichen, in denen diese von dem Verbinder 104 bedeckt sind, beabstandet zu der die intermetallische Verbindung symbolisierenden Ellipse 264.

Bevorzugte Dimensionierungen des Pads bzw. Lötpunktes sind Folgende:
Länge des Pads: 5 mm bis 10 mm
Breite des Pads: 5 mm
Länge jeweiligen zweiten Randbereichs: 5 mm bis 8 mm
Minimale Breite des Spalts zwischen Pad und Aluminiumschicht in dem von dem Verbinder überdeckten Bereich: 0,5 mm
Dicke des Pads: 10 µm bis 15 µm
Fläche des Pads: möglichst klein, um Ag zu sparen
Breite des legierten Bereichs: 0,1 mm bis ca. 2 mm.

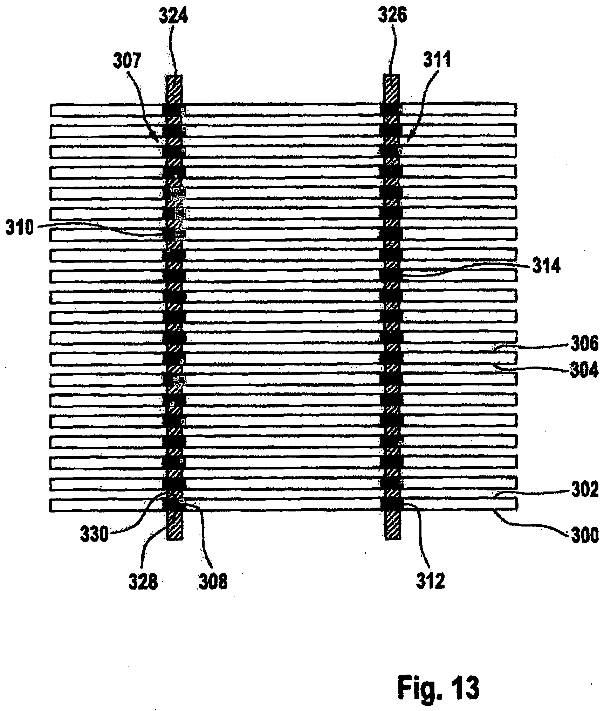

Anhand der Fig. 13 bis 16 sollen der erfindungsgemäßen Lehre gehorchende Frontkontakte einer Solarzelle erläutert werden. Dabei werden grundsätzlich für gleiche Elemente gleiche Bezugszeichen verwendet.

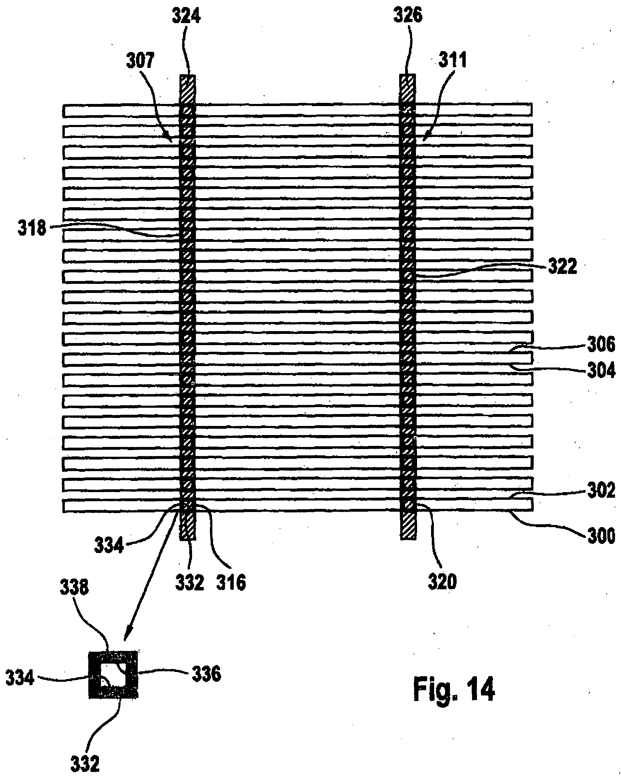

In bekannter Weise sind auf der Frontseite einer Solarzelle sogenannte Kontaktfinger 300, 302, 304, 306 angeordnet, die im Wesentlichen parallel zueinander verlaufen. Die Kontaktfinger 300, 302, 304, 306 können an ihren Enden untereinander verbunden werden, um einen Stromfluss auch dann zu ermöglichen, wenn in einem Bereich ein Kontaktfinger unterbrochen sein sollte. Quer zu der Längserstreckung der Kontaktfinger 300, 302, 304, 306 verlaufen in bekannter Weise Busbars 307, 311, die erfindungsgemäß aus aneinander gereihten Abschnitten bestehen, die gemäß Fig. 13 durch gefüllte Quadrate 308, 310 bzw. 312, 314 oder durch offene Rechtecke wie Quadrate 316, 318 bzw. 320, 322 gemäß Fig. 14 symbolisiert sind. Über die entsprechenden Busbars 307, 311 bzw. deren Abschnitte 308, 310, 312, 314, 316, 318, 320, 322 erstreckt sich jeweils ein Verbinder 324, 326, der mit den Busbars 307, 311 stoffschlüssig verbunden ist. Über die Verbinder 324, 326 erfolgt sodann ein Verschalten von Solarzellen.

Wie sich aus den Fig. 13 und 14 ergibt, ist jeder Busbar nicht durchgehend ausgebildet, sondern besteht aus den Abschnitten 308, 310, 312, 314, 316, 318, 320, 322, die über die Verbinder 324, 326 elektrisch leitend verbunden werden. Dabei erstreckt sich jeder Abschnitt 308, 310, 312, 314, 316, 318, 320, 322 über zumindest zwei Kontaktfinger 300, 302, 304, 306.

Somit überdeckt nach dem Ausführungsbeispiel der Fig. 13 jeder Verbinder 324, 326 pro Paar von Kontaktfingern 300, 302 bzw. 304, 306 zwei Lötkanten mit der Folge, dass Zugkräfte verteilt sind und die Gefahr einer Rissbildung unterbleibt. Die Lötkanten des jeweiligen Abschnitts 308, 310, 312, 314 sind beispielhaft mit den Bezugszeichen 328, 330 am Abschnitt 308 gekennzeichnet.

Bei der Ausbildung der Abschnitte 316, 318, 320, 322 in Form eines Hohlrechtecks stehen zwei weitere Lötkanten zur Verfügung, so dass pro Paar Kontaktfingern 300, 302 bzw. 304, 306 insgesamt vier Lötkanten von dem jeweiligen Verbinder 324, 326 abgedeckt werden, so dass eine Erhöhung der Zugkraftverteilung erfolgt. Die entsprechenden Lötkanten eines der Abschnitte - im Ausführungsbeispiel des Abschnitts 316 - sind mit dem Bezugszeichen 332, 334, 336, 338 gekennzeichnet.

Weist im Ausführungsbeispiel der Fig. 13 und 14 der jeweilige Abschnitt 308, 310, 312, 314, 316, 318, 320, 322 in Draufsicht eine Rechteckgeometrie auf, so ist eine andere Geometrie gleichfalls möglich, insbesondere eine Kreis- oder Ovalgeometrie.

Des Weiteren können die Abschnitte der Busbars auch mehr als zwei Kontaktfinger 300, 302, 304, 306 abdecken, so dass sich entsprechend die Anzahl der Lötkanten reduziert.

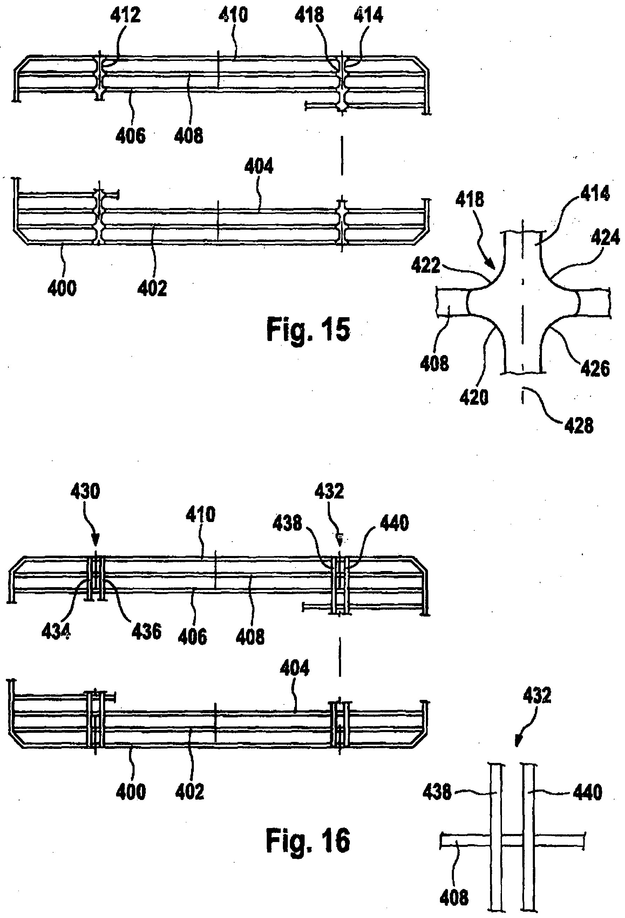

Ist der Busbar 307, 311 nach dem Ausführungsbeispiel der Fig. 13 und 14 in Einzelabschnitte unterteilt, so wird die erfindungsgemäße Lehre auch dann realisiert, wenn der Busbar durchgehend ausgebildet wird, sofern zusätzliche Lötkanten zur Verfügung gestellt werden. Dies soll anhand der Fig. 14 und 15 verdeutlicht werden.

Gemäß Fig. 15 werden Kontaktfinger 400, 402, 404, 406, 408, 410 von Busbars 412, 414 verbunden, die jedoch im Kontaktbereich mit den Fingern 400, 402, 404, 406, 408, 410 breitenmäßig erweitert sind, wie die Detaildarstellung in der Fig. 15 verdeutlicht. In dieser ist der Schnittpunkt 418 zwischen dem Kontaktfinger 408 und dem Busbar 414 dargestellt. Man erkennt, dass im Überlappungsbereich oder Schnittpunkt 418 der Busbar 414 erweitert ist, so dass sich im Schnittpunkt 418 insgesamt vier Lötkanten 420, 422, 424, 426 ergeben, die schräg zur Längsrichtung 428 des Busbars 414 verlaufen. Dabei sollten die die Längsränder bildenden Lötkanten 420, 422, 424, 426 des Busbars 414 stetig in die nicht näher gekennzeichneten Längsränder des Kontaktfingers 408 übergehen.

Bei dem Ausführungsbeispiel der Fig. 16 verlaufen senkrecht zu den Kontaktfingern 400, 402, 404, 406, 408, 410 Busbars 430, 432, die als Doppelstreifen ausgebildet sind, d. h., jeder Busbar 430, 432 besteht aus zwei parallel zueinander verlaufenden streifenoder linienförmigen Abschnitten 434, 436 bzw. 438, 440. Hierdurch ergeben sich Busbars 430, 432 mit vier Längslötkanten, wie die Detaildarstellung in Fig. 16 verdeutlicht. Dabei kann der jeweilige eine Lötkante bildende Längsrand der Abschnitte 434, 436, 438 440 der Busbars 430, 432 stetig in die jeweiligen Längsränder der Kontaktfinger 400, 402, 404, 406, 408, 410 übergehen, wie dies anhand der Fig. 15 verdeutlicht ist.

Verlaufen nach dem Ausführungsbeispiel der Fig. 16 die Lötkanten in Längsrichtung des Verbinders, also in Zugrichtung, so ist bei den anderen Ausführungsbeispielen ein Verlauf quer bzw. senkrecht zur Längsrichtung vorgesehen. Auch Mischformen sind möglich, wie die Fig. 15 verdeutlicht, d. h., dass Lötkanten quer zur Längsrichtung, schräg zur Längsrichtung und in Längsrichtung zumindest abschnittsweise verlaufen können.

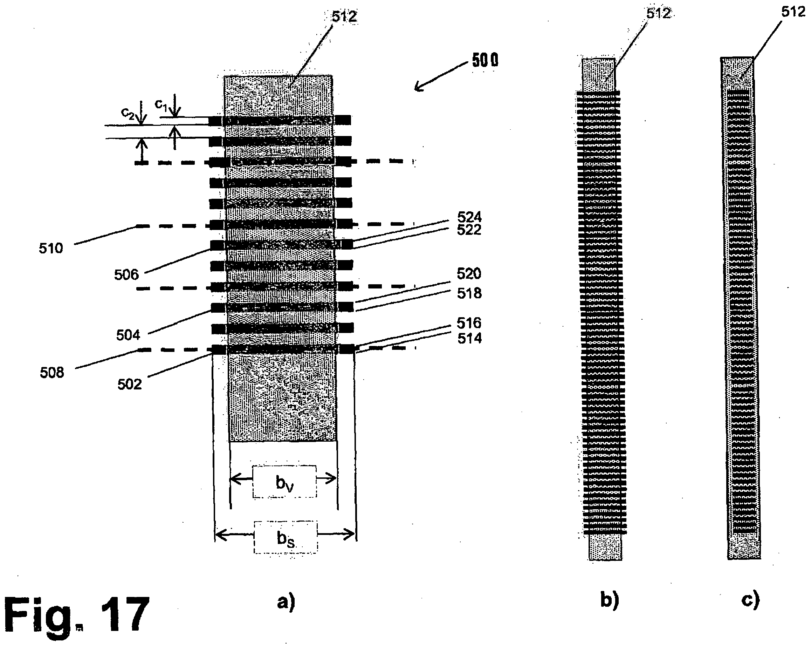

Den Fig. 17 a) bis 17 c) ist eine weitere hervorzuhebende Ausführungsform der erfindungsgemäßen Lehre zur Gestaltung eines Frontseitenkontaktes einer Solarzelle zu entnehmen. So besteht der Busbar 500 aus streifenförmigen Abschnitten, von denen einige mit dem Bezugszeichen 502, 504, 506 gekennzeichnet sind. Die Abschnitte, die eine Rechteckgeometrie besitzen können, weisen eine Breite c₁ auf. Der Abstand benachbarter Ränder von zwei aufeinander folgenden Abschnitten beträgt c₂. Andere Geometrien wie ein bogenförmiger Verlauf eines jeden Abschnitts, wodurch sich eine Verlängerung der jeweiligen Lötkanten ergibt, ist gleichfalls möglich.

Wie der zeichnerischen Darstellung gemäß Fig. 17 a) zu entnehmen ist, ist nicht jeder Abschnitt mit einen Kontakt- oder Gridfinger 508, 510 verbunden. Im Ausführungsbeispiel ist der Abschnitt 502 mit dem Finger 508 verbunden. Die Finger 508, 510 sind durch gestrichelte Linien angedeutet.

Quer zu den Abschnitten 502, 504, 506 erstreckt sich ein Verbinder 512, der mit den Abschnitten stoffschlüssig verbunden ist. Somit besteht die Kontaktstruktur gemäß der Fig. 17a) bis 17c) aus vielen einzelnen, quer zur Richtung des Verbinders 512 verlaufenden Abschnitten 502, 504, 506 aus Kontaktmaterial, wobei auf engem Raum eine Vielzahl von Lötkanten entstehen, von denen einige mit den Bezugszeichen 514, 516, 518, 520, 522, 524 gekennzeichnet sind.

Die Zugkraft des Verbinders 512 wird auf die einzelnen n-Abschnitte 502, 504, 506, also Kontaktstrukturen gleichmäßig aufgeteilt, so dass an jeder Lötkante 514, 516, 518, 520, 522, 524 die Kraft Fₙ = F _{Verbinder} /2n wirksam wird.

Übt der Verbinder eine Kraft von z. B. 30 N auf die äußeren Lötkanten eines zusammenhängenden Busbars aus, so wird die Kraft für den Fall, dass der Busbar entsprechend der erfindungsgemäßen Lehre z. B. in n = 10 Abschnitte oder Strukturen unterteilt ist, durch 20 geteilt, so dass nur noch 1,5 N pro Lötkante wirksam werden. Hierdurch wird die mechanische Belastung des Wafers reduziert und der Stress auf 2n Lötkanten aufgeteilt.

Die Kontakt- oder Gridfinger 508, 510, die erwähntermaßen gestrichelt gezeichnet sind, münden in einigen der als Kontaktstrukturen bezeichneten Abschnitte, um den elektrischen Anschluss der Stromsammler zu gewährleisten.

Wie sich aus der zeichnerischen Darstellung ergibt, verlaufen mehrere Abschnitte bzw. Kontaktstrukturen wie die Kontaktstrukturen 504, 506, die jeweils zwei Lötkanten aufweisen, zwischen bzw. außerhalb der Finger 508, 510, so dass der mechanische Stress wirkungsvoll reduziert werden kann.

Aus den Darstellungen der Fig. 17 b) und 17 c) ergibt sich, dass die Breite der Abschnitte 502, 504, 506, also der Kontaktstrukturen unabhängig von der Breite des Verbinders 512 ist, also größer oder kleiner als die Breite des Verbinders 512 sein kann. Gemäß der Fig. 17 b) erstrecken sich die streifenförmigen Abschnitte oder Strukturen seitlich außerhalb des Verbinders 512, wohingegen bei der Ausführungsform der Fig. 17 c) die Abschnitte vollständig von dem Verbinder 512 abgedeckt werden.

Bevorzugte Maße für die Kontaktstruktur gemäß Fig. 17 sind:
c₁ = 200 µm bis 500 µm
c₂ = 200 µm bis 500 µm
b_{V} = Breite des Verbinders 512, z. B. 1,5 mm, 1,8 mm und 2,0 mm
b_{S} = Breite der Kontaktstruktur bzw. der Abschnitte 502, 504, 506, z. B.
   1,0 mm bis 1,8 mm für b_{V} = 1,5 mm
   1,2 mm bis 2,2 mm für b_{V} = 1,6 mm
   1,8 mm bis 2,4 mm für b_{V} = 2,0 mm.

## Patentansprüche

1. Solarzelle umfassend ein Halbleitersubstrat mit Front- und Rückseitenkontakt, wobei der Frontseitenkontakt Kontaktfinger (300, 302, 304, 306) und zumindest einen quer zu diesen verlaufenden aus mehreren zueinander beabstandeten Abschnitten bestehenden Busbar (307, 311) umfasst, entlang dem ein mit diesem stoffschlüssig verbundener Verbinder (324, 326) verläuft, wobei zumindest zwei Kontaktfinger mit jeweils einem zumindest zwei Lötkanten (328, 330) aufweisenden Abschnitt des Busbars verbunden sind,
**dadurch gekennzeichnet,**
**dass** der Abschnitt (316, 318, 320, 322) in Draufsicht eine ring- oder hohlrechteckförmige Geometrie zur Bildung von vier Lötkanten (332, 334, 336, 338) aufweist.

2. Solarzelle nach Anspruch 1,
**dadurch gekennzeichnet,**
**dass** der Rückseitenkontakt eine aus einem ersten elektrisch leitenden Material bestehende oder enthaltende Schicht (30, 100) mit Aussparungen (102) aufweist, in denen Lötpunkte (Pads) (32, 106, 132, 144, 154, 164, 174, 180, 182) angeordnet sind, die aus einem zweiten elektrisch leitenden Material bestehen, das im Kontaktbereich mit dem ersten elektrisch leitenden Material eine intermetallische Verbindung bildet, wobei in zumindest zwei Aussparungen angeordnete Lötpunkte mit einem entlang einer Geraden verlaufenden Verbinder (36, 104) in jeweils einem Lötbereich (122) eines jeden Pads verbunden sind und sich der Verbinder im Abstand zu der Schicht über Lötkanten (108, 110, 111, 113, 114, 142, 146, 148, 160, 162, 166, 168, 192, 194, 196, 198, 202, 204, 206, 208) des Lötpunkts erstreckt,
wobei der Verbinder (36) mit den Lötpunkten (32) ausschließlich außerhalb der intermetallischen Verbindung stoffschlüssig verbunden ist und/oder dass sich der Verbinder (104) über zumindest drei Lötkanten (108, 110, 111, 113, 114, 142, 146, 148, 160, 162, 166, 168, 192, 194, 196, 198, 202, 204, 206, 208) erstreckt, wobei die zumindest drei quer zu der Geraden verlaufende Lötkanten eine von dem Verbinder (104) abgedeckte Länge aufweisen, die zumindest 2,5-fache Breite B des Verbinders (104) ist.

3. Solarzelle nach Anspruch 2,
**dadurch gekennzeichnet,**
**dass** eine erste Lötkante (108, 110, 111, 113, 140, 142, 146, 148, 160, 162, 166, 168, 192, 208) ein von der Geraden geschnittener erster Randbereich des Lötpunkts (106, 132, 144, 154, 164, 174, 180, 182) ist, der beabstandet zu der Schicht (100) bzw. deren von dem Verbinder (104) abgedeckten Schichtkante (112, 114, 170, 172, 216, 218) verläuft.

4. Solarzelle nach zumindest Anspruch 2,
**dadurch gekennzeichnet,**
**dass** der in der Aussparung (102) angeordnete Lötpunkt (180, 182) zumindest in dem von dem Verbinder (104) abgedeckten Bereich der Aussparung (102) aus zumindest zwei zueinander beabstandeten Abschnitten (184, 186, 188, 190) besteht.

5. Solarzelle nach zumindest Anspruch 4,
**dadurch gekennzeichnet,**
**dass** jeder der zueinander beabstandeten Abschnitte (184, 186, 188, 190) des Lötpunkts (118) zwei Lötkanten (192, 194, 196, 198, 202, 204, 206, 208) aufweist.

6. Solarzellen nach zumindest Anspruch 5,
**dadurch gekennzeichnet,**
**dass** die Abschnitte (184, 186, 188, 190) des Lötpunkts (180) in der Aussparung (102) getrennt zueinander angeordnet sind.

7. Solarzelle nach zumindest einem der vorhergehenden Ansprüche,
**dadurch gekennzeichnet,**
**dass** den ersten Randbereich begrenzende Lötkante (140,142, 146, 148, 166, 168) zumindest im Lötbereich (122) in Bezug auf die zugewandte Schichtkante (112, 114, 170, 172) einem konvex- und/oder konkavförmigen Bogenabschnitt folgt.

8. Solarzelle nach zumindest einem der vorhergehenden Ansprüche,
**dadurch gekennzeichnet,**
**dass** der Lötpunkt (154) aus zwei ineinander übergehenden linsenförmigen oder in Draufsicht ovalförmigen Abschnitten (156, 158) besteht, deren Längsachsen entlang der Geraden verlaufen, wobei die Lötkante (160, 162) des ersten Randbereichs eine V-Geometrie mit gekrümmt verlaufenden Schenkeln aufweist.

9. Solarzelle nach zumindest einem der vorhergehenden Ansprüche,
**dadurch gekennzeichnet,**
**dass** der Lötpunkt (164) in Draufsicht eine Reckteckgeometrie aufweist, wobei jeweilige Lötkante (166, 168) des ersten Randbereichs eine konkav verlaufende Bogengeometrie und zugewandte Schichtkante (170, 172) jeweils eine konkav verlaufende Bogengeometrie aufweist.

10. Solarzelle nach zumindest einem der vorhergehenden Ansprüche,
**dadurch gekennzeichnet,**
**dass** der Lötpunkt (174) in seinem Lötbereich (122) zumindest eine kreis- oder ovalförmige Aussparung (107, 176, 178) aufweist, die zumindest bereichsweise bei aufgelötetem Verbinder (104) von diesem abgedeckt ist.

11. Solarzelle nach zumindest Anspruch 10,
**dadurch gekennzeichnet,**
**dass** die kreisförmige Aussparung (176) vollständig und/oder die mit ihrer Längsachse quer zur Längsachse des Verbinders (104) verlaufende ovalförmige Aussparung (178) vorzugsweise ausschließlich bereichsweise von dem Verbinder abgedeckt ist.

12. Solarzelle nach zumindest einem der vorhergehenden Ansprüche,
**dadurch gekennzeichnet,**
**dass** miminaler Abstand b zwischen Lötkante (108, 110) des ersten Randbereichs des Pads (174) und zugewandter Schichtkante (112, 114) der Schicht (100) beträgt b ≥ 500 µm, insbesondere 500 µm ≤ b ≤ 10 mm, und/oder dass minimaler Abstand a zwischen Randbereich der stoffschlüssigen Verbindung zwischen dem Verbinder (36) und dem Lötpunkt (32) und der intermetallischen Verbindung (35) 500 µm beträgt, insbesondere 500 µm ≤ a ≤ 2 mm.

## Claims

1. A solar cell comprising a semiconductor substrate with contacts on the front and back sides, wherein the front-side contact comprises contact fingers (300, 302, 304, 306) and at least one busbar (307, 311) running crosswise to these fingers, made of several sections at a distance from one another, along which runs a connector (324, 326) which is cohesively connected to this busbar, wherein at least two contact fingers are each connected to a section of the busbar having at least two soldering edges (328, 330),
**characterized in that**
the section (316, 318, 320, 322) in top view has an annular or hollow-rectangular geometry for the formation of four soldering edges (332, 334, 336, 338).

2. The solar cell according to claim 1
**characterized in that**
the back-side contact has a layer (30, 100) with recesses (102) that is composed of or containing a first electrically conducting material, with soldering points (pads) (32, 106, 132, 144, 154, 164, 174, 180, 182) arranged in these recesses, these points or pads being composed of a second electrically conducting material which forms an intermetallic compound in the contact region with the first electrically conducting material, wherein soldering points arranged in at least two recesses can be connected to a connector (36, 104) running along a straight line in a soldering region (122) of each pad in each case and the connector extends at a distance to the layer over soldering edges (108, 110, 111, 113, 114, 142, 146, 148, 160, 162, 166, 168, 192, 194, 196, 198, 202, 204, 206, 208) of the soldering point,
wherein
the connector (36) is cohesively connected to the soldering points (32) exclusively outside of the intermetallic compound, and/or that the connector (104) extends over at least three soldering edges (108, 110, 111, 113, 114, 142, 146, 148, 160, 162, 166, 168, 192, 194, 196, 198, 202, 204, 206, 208), wherein the at least three soldering edges running crosswise to the straight line have a length covered by the connector (104) that is at least 2.5 times the width B of the connector (104).

3. The solar cell according to claim 2,
**characterized in that**
a first soldering edge (108, 110, 111, 113, 140, 142, 146, 148, 160, 162, 166, 168, 192, 208) is a first edge region of the soldering point (106, 132, 144, 154, 164, 174, 180, 182) intersected by the straight line, this region running at a distance to the layer (100) or its layer edge (112, 114, 170, 172, 216, 218) covered by the connector (104).

4. The solar cell according to at least claim 2,
**characterized in that**
the soldering point (180, 182) arranged in the recess (102) is composed of at least two sections (184, 186, 188, 190) at a distance from one another, at least in the region of the recess (102) covered by the connector (104).

5. The solar cell according to at least claim 4,
**characterized in that**
each of the sections (184, 186, 188, 190) of the soldering point (118) that are at a distance from one another has two soldering edges (192, 194, 196, 198, 202, 204, 206, 208).

6. The solar cell according to at least claim 5,
**characterized in that**
the sections (184, 186, 188, 190) of the soldering point (180) are arranged separately from one another in the recess (102).

7. The solar cell according to at least one of the preceding claims,
**characterized in that**
soldering edge (140,142, 146, 148, 166, 168) delimiting the first edge region follows a convex and/or concave arcuate section, at least in the soldering region (122) relative to the facing layer edge (112, 114, 170, 172).

8. The solar cell according to at least one of the preceding claims,
**characterized in that**
the soldering point (154) is composed of two sections (156, 158) merging into one another in a lenticular manner or oval-shaped in top view, the longitudinal axes of which run along the straight line, wherein the soldering edge (160, 162) of the first edge region has a V geometry with curved running legs.

9. The solar cell according to at least one of the preceding claims,
**characterized in that**
the soldering point (164) has a rectangular geometry in top view, wherein the respective soldering edge (166, 168) of the first edge region has a concavely running arcuate geometry and facing layer edge (170, 172) each has a concavely running arcuate geometry.

10. The solar cell according to at least one of the preceding claims,
**characterized in that**
the soldering point (174), in its soldering region (122), has at least one circular or oval recess (107, 176, 178), which is covered at least in regions by the connector (104) when it is soldered on.

11. The solar cell according to at least claim 10,
**characterized in that**
the circular recess (176) is completely covered by the connector and/or the oval recess (178) running with its longitudinal axis crosswise to the longitudinal axis of the connector (104) is covered by the connector preferably exclusively in regions.

12. The solar cell according to at least one of the preceding claims,
**characterized in that**
the minimum distance b between soldering edge (108, 110) of the first edge region of the pad (174) and facing layer edge (112, 114) of the layer (100) amounts to b ≥ 500 µm, in particular 500 µm ≤ b ≤ 10 mm, and/or **in that** the minimum distance a between the edge region of the cohesive connection between the connector (36) and the soldering point (32) and the intermetallic compound (35) amounts to 500 µm, in particular 500 µm ≤ a ≤ 2 mm.

## Revendications

1. Cellule solaire comprenant un substrat semi-conducteur présentant un contact avant et un contact arrière, sachant que le contact avant comprend des doigts de contact (300, 302, 304, 306) et au moins une barre omnibus (307, 311), s'étendant transversalement par rapport auxdits doigts de contact et constituée de plusieurs parties non jointives, le long de laquelle s'étend une liaison (324, 326), reliée à ladite barre omnibus par liaison de matière, sachant qu'au moins deux doigts de contact sont reliés respectivement à une partie de la barre omnibus présentant au moins deux bords de brasage (328, 330),
**caractérisée en ce**
**que** la partie (316, 318, 320, 322) présente en élévation une géométrie annulaire ou rectangulaire évidée afin de former quatre bords de brasage (332, 334, 336, 338).

2. Cellule solaire selon la revendication 1,
**caractérisée en ce**
**que** le contact arrière présente une couche (30, 100) constituée d'un ou contenant un premier matériau électroconducteur et présentant des évidements (102) dans lesquels sont disposés des points de brasage *(pads)* (32, 106, 132, 144, 154, 164, 174, 180, 182) constitués d'un deuxième matériau électroconducteur qui forme une liaison intermétallique dans la zone de contact avec le premier matériau électroconducteur, sachant que des points de brasage disposés dans au moins deux évidements sont reliés à une liaison (36, 104) s'étendant le long d'une droite dans une zone de brasage (122) respective de chaque *pad,* et que la liaison s'étend à une distance de la couche au-dessus des bords de brasage (108, 110, 111, 113, 114, 142, 146, 148, 160, 162, 166, 168,192, 194, 196, 198, 202, 204, 206, 208) du point de brasage,
sachant que la liaison (36) est reliée par liaison de matière aux points de brasage (32) exclusivement hors de la liaison intermétallique et/ou que la liaison (104) s'étend au-dessus d'au moins trois bords de brasage (108, 110, 111, 113, 114, 142, 146, 148, 160, 162, 166, 168, 192, 194, 196, 198, 202, 204, 206, 208), et que les au moins trois bords de brasage s'étendant transversalement par rapport à la droite présentent une longueur recouverte par la liaison (104) qui est au moins égale à 2,5 fois la largeur B de la liaison (104).

3. Cellule solaire selon la revendication 2,
**caractérisée en ce**
**qu'**un premier bord de brasage (108, 110, 111, 113, 140, 142, 146, 148, 160, 162, 166, 168, 192, 208) est une première zone marginale du point de brasage (106, 132, 144, 154, 164, 174, 180, 182) coupée par la droite et qui s'étend à distance de la couche (100) ou de son bord de couche (112, 114, 170, 172, 216, 218) recouvert par la liaison (104).

4. Cellule solaire selon au moins la revendication 2,
**caractérisée en ce**
**que** le point de brasage (180, 182) situé dans l'évidement (102) est constitué, au moins dans la zone de l'évidement (102) recouverte par la liaison (104), par au moins deux parties (184, 186, 188, 190) non jointives.

5. Cellule solaire selon au moins la revendication 4,
**caractérisée en ce**
**que** chacune des parties non jointives (184, 186, 188, 190) du point de brasage (118) présente deux bords de brasage (192, 194, 196, 198, 202, 204, 206, 208).

6. Cellule solaire selon au moins la revendication 5,
**caractérisée en ce**
**que** les parties (184, 186, 188, 190) du point de brasage (180) sont disposées séparément les unes des autres dans l'évidement (102).

7. Cellule solaire selon au moins une des revendications précédentes,
**caractérisée en ce**
**que** le bord de brasage (140, 142, 146, 148, 166, 168) délimitant la première zone marginale suit au moins dans la zone de brasage (122) une partie arquée convexe ou concave par rapport au bord de couche (112, 114, 170, 172) lui faisant face.

8. Cellule solaire selon au moins une des revendications précédentes,
**caractérisée en ce**
**que** le point de brasage (154) est constitué de deux parties (156, 158) se fondant l'une dans l'autre, de forme lenticulaire ou de forme ovale en élévation, dont les axes longitudinaux s'étendent le long de la droite, sachant que le bord de brasage (160, 162) de la première zone marginale présente une géométrie en V avec branches incurvées.

9. Cellule solaire selon au moins une des revendications précédentes,
**caractérisée en ce**
**que** le point de brasage (164) présente en élévation une géométrie rectangulaire, sachant que chaque bord de brasage (166, 168) de la première zone marginale présente une géométrie arquée concave et que chaque bord de couche (170, 172) lui faisant face présente une géométrie arquée concave.

10. Cellule solaire selon au moins une des revendications précédentes,
**caractérisée en ce**
**que** dans sa zone de brasage (122), le point de brasage (174) présente au moins un évidement (107, 176, 178) circulaire ou ovale, qui est recouvert au moins partiellement par la liaison (104) lorsque cette dernière est brasée par-dessus.

11. Cellule solaire selon au moins la revendication 10,
**caractérisée en ce**
**que** l'évidement circulaire (176) est recouvert intégralement par la liaison et/ou que l'évidement ovale (178) dont l'axe longitudinal s'étend transversalement à l'axe longitudinal de la liaison (104) est de préférence recouvert exclusivement partiellement par ladite liaison.

12. Cellule solaire selon au moins une des revendications précédentes,
**caractérisée en ce**
**que** la distance minimale b entre le bord de brasage (108,110) de la première zone marginale du *pad* (174) et le bord de couche (112, 114) de la couche (100) lui faisant face est telle que b ≥ 500 µm, en particulier 500 µm ≤ b ≤ 10 mm, et/ou que la distance minimale a entre la zone marginale de la liaison par matière entre la liaison (36) et le point de brasage (32) et la liaison intermétallique (35) est de 500 µm, en particulier 500 µm ≤ a ≤ 2 mm.
